# FASCICULE DE BREVET EUROPEEN

(11) **EP 2 862 000 B1**
(45) Date de publication et mention de la délivrance du brevet: **04.05.2016**
(21) Numéro de dépôt: 13728429.5
(22) Date de dépôt: 14.06.2013
(51) Int. Cl.: G01R 33/028

(54) **CAPTEUR DE CHAMP MAGNETIQUE A FORCE DE LAPLACE**
SENSOR FÜR MAGNETFELDER MIT LAPLACE-KRAFT
SENSOR FOR MAGNETIC FIELDS WITH LAPLACE FORCE

(30) Priorité: 15.06.2012 FR 1255597
(43) Date de publication de la demande: 22.04.2015
(73) Titulaire: Commissariat à l'Énergie Atomique et aux Énergies Alternatives, 75015 Paris (FR)
(72) Inventeur: ROBERT, Philippe, F-38000 Grenoble (FR); ETTELT, Dirk, 45892 Gelsenkirchen (DE); WALTHER, Arnaud, F-38000 Grenoble (FR)
(74) Mandataire: GIE Innovation Competence Group
(86) Numéro de dépôt international: PCT/EP2013/062432
(87) Numéro de publication internationale: WO 2013/186383

(56) Documents cités:
- WO-A1-2010/084165
- US-A1- 2006 076 947
- US-B1- 7 642 692

## Description

L'invention concerne un capteur de champ magnétique à force de Laplace ainsi qu'un procédé d'utilisation de ce capteur.

Les capteurs de champ magnétique à force de Laplace peuvent être utilisés pour mesurer une composante du champ magnétique terrestre ou une composante d'un champ magnétique généré par un conducteur électrique ou une autre source de champ magnétique.

Par composante du champ magnétique, on désigne l'amplitude de la projection orthogonale du champ magnétique sur un axe de mesure du capteur.

Des capteurs connus comportent :
- un substrat s'étendant essentiellement dans un plan appelé plan du substrat,
- au moins un conducteur électrique apte à être parcouru par un courant électrique, ce conducteur électrique comportant une partie mobile, suspendue au-dessus du substrat, apte à se déplacer dans une direction de déplacement lorsqu'elle est soumise à une force de Laplace,
- des liaisons mécaniques raccordant mécaniquement cette partie mobile au substrat et raccordant électriquement la partie mobile à des plots d'alimentation en courant disposés sur le substrat,
   au moins une jauge apte à mesurer une grandeur physique représentative de l'amplitude du déplacement de la partie mobile, cette jauge comportant au moins une première et une seconde parties,
- un levier suspendu déplaçable en rotation autour d'un axe de rotation perpendiculaire à la direction de déplacement de la partie mobile, ce levier comportant un premier et un second points d'attache, le premier point d'attache étant mécaniquement raccordé à la partie mobile pour entraîner le levier en rotation autour de l'axe de rotation en réponse à un déplacement de la partie mobile, et le second point d'attache étant directement mécaniquement raccordé à la première partie de la jauge.

Par exemple, de tels capteurs sont décrits dans les articles A1 et A2 suivants :
- A1 : V. Beroulle et al, « Monolithic piezoresistive CMOS magnetic field sensors », Sensors and actuators A, vol 103, pages 23-32, 2003,
- A2 : A.L. Herrera-May et al, « A resonant magnetic field microsensor with high quality factor at atmospheric pressure », J. Micromechanical Microengineering, 19 (2009) 015016.

De l'état de la technique est également connu de :
- US7 642 692 B1, et
- US 2006/076947 et WO2010/084165 A1.

Il est souhaitable d'optimiser ces capteurs notamment pour améliorer leur sensibilité ou régler leur bande passante. Toutefois, en pratique, cette tâche s'avère particulièrement difficile à réaliser. Ce point est illustré par les quelques exemples suivants.

Pour augmenter la sensibilité du capteur décrit dans l'article A1 ou A2, il pourrait être envisagé d'éloigner le conducteur électrique sur lequel s'exerce la force de Laplace de la jauge en augmentant la longueur du levier. En effet, accroître la longueur du levier permet d'augmenter la force qui s'exerce sur la jauge, et donc d'accroître la sensibilité du capteur. Toutefois, augmenter la longueur du levier modifie la fréquence de résonance du levier. Or, les conducteurs électriques des capteurs des articles A1 et A2 doivent être alimentés avec un courant alternatif dont la fréquence est choisie égale à la fréquence de résonance mécanique du levier. Par conséquent, accroître la longueur du levier conduit à travailler à des fréquences qui peuvent se trouver en dehors de la plage de fréquences de travail souhaitée. Par exemple, plus la fréquence de travail est basse, plus le capteur est sensible aux vibrations mécaniques. De plus, dans le cas des articles A1 et A2, les jauges sont intégrées sur le levier. Dans ces conditions pour que les jauges puissent mesurer une variation de contrainte, il faut que le levier soit déformable. En effet, dans le cas contraire, les jauges ne mesuraient aucun signaux. Dès lors, puisque le levier est déformable on ne profite pas directement d'un effet mécanique de bras de levier en augmentant la longueur du levier. Pour obtenir cet effet, il faudrait que le levier soit rigide.

Dans les capteurs connus, si l'on souhaite obtenir une bande passante donnée pour le capteur, il faut aussi jouer sur la longueur du levier et/ou sur la raideur des liaisons mécaniques. De façon similaire à ce qui a été indiqué ci-dessus, ces modifications modifient aussi nécessairement la sensibilité du capteur, ce qui n'est pas souhaité.

Enfin, dans les capteurs connus, on peut aussi envisager de réduire la raideur des liaisons mécaniques pour accroître l'amplitude du déplacement de la partie mobile du conducteur électrique. Toutefois, encore une fois, une telle modification ne peut pas être réalisée sans modifier d'autres aspects du fonctionnement du capteur tels que sa fréquence de résonance.

L'invention vise donc à proposer un capteur de champ magnétique à force de Laplace dont l'architecture est plus simple à optimiser. Elle a donc pour objet un capteur conforme à la revendication 1.

Dans le capteur ci-dessus, du fait que la charnière qui raccorde le levier au substrat est distinct des liaisons mécaniques et électriques du conducteur, il est possible d'optimiser séparément les caractéristiques mécaniques du conducteur et du levier. Par exemple, dans le capteur ci-dessus, la fréquence de résonance mécanique est essentiellement déterminée par les caractéristiques mécaniques du levier, de la charnière et de la jauge. De plus, il est possible d'obtenir un effet de bras de levier important car :
- le levier est rigide, et
- la jauge est fixée suivant l'une de ses extrémités sur le levier rigide et suivant l'autre extrémité à un encastrement fixe, ce qui permet d'avoir une sensibilité optimisée.

Par levier « rigide », on désigne ici un levier dont la raideur en flexion, au niveau du premier point d'attache, dans la direction de déplacement de la partie mobile, est supérieure et, de préférence au moins dix ou cent fois supérieure, à la raideur en compression de la jauge. La raideur en flexion du levier est celle mesurable ou calculable lorsque la charnière est remplacée par un ancrage de raideur infinie et ne permettant aucun degré de liberté. La raideur en compression de la jauge est la raideur en compression de la poutre piézorésistive lorsque cette jauge comporte une poutre piézorésistive.

A l'inverse, il est aussi possible d'optimiser les caractéristiques mécaniques du conducteur pour accroître l'amplitude de son déplacement en réponse à un champ magnétique sans modifier les caractéristiques du levier et de la charnière.

Cette indépendance des caractéristiques mécaniques du levier et du conducteur facilite donc l'optimisation et le dimensionnement des différents éléments du capteur. En particulier, cela rend possible le développement de capteurs plus sensibles.

Les modes de réalisation de ce capteur peuvent comporter une ou plusieurs des caractéristiques des revendications dépendantes.

Ces modes de réalisation présentent en outre les avantages suivants :
- placer le second point d'attache plus près de l'axe de rotation du levier que le premier point d'attache permet d'amplifier la force exercée par le conducteur ;
- utiliser une jauge de contrainte suspendue accroît la sensibilité du capteur car l'ensemble de la contrainte mécanique à mesurer se concentre à l'intérieur de la jauge alors que lorsque la jauge est placée sur une poutre une partie de la contrainte à mesurer va dans la poutre ;
- diminuer la section transversale de la jauge de contrainte permet d'accroître la sensibilité du capteur ;
- utiliser deux jauges placées de part et d'autre du levier permet de réaliser une mesure différentielle plus robuste ;
- répartir le poids du levier pour que son centre de gravité soit proche de son axe de rotation rend le capteur plus insensible aux chocs et aux vibrations ;
- avoir des premier et troisième points d'attache symétriques par rapport à l'axe de rotation du levier rend le capteur plus insensible aux chocs et aux vibrations ;
- avoir une partie mobile rigide facilite l'optimisation de la forme du conducteur car la partie mobile n'a pas à se déformer sous l'effet de la force de Laplace pour se déplacer ;
- raccorder la partie mobile au premier point d'attache du levier par l'intermédiaire d'une liaison mécanique en forme de méandre limite la transmission au levier de déformation non souhaitée du conducteur ;
- l'utilisation de plusieurs conducteurs en parallèle accroît la sensibilité du capteur.

L'invention a également pour objet un procédé d'utilisation du capteur ci-dessus conforme à la revendication 13.

L'invention sera mieux comprise à la lecture de la description qui va suivre, donnée uniquement à titre d'exemple non limitatif et faite en se référant aux dessins sur lesquels :
- la figure 1 est une illustration schématique d'un premier mode de réalisation d'un capteur de champ magnétique à force de Laplace,
- les figures 2 à 8 sont des illustrations schématiques de différentes étapes de fabrication du capteur de la figure 1,
- les figures 9, 11, 12, 14 à 18 et 20 sont des illustrations schématiques en vue de dessus de différents autres modes de réalisation possibles d'un capteur à force de Laplace,
- la figure 10 est une illustration en coupe verticale d'une jauge de contrainte utilisée dans le mode de réalisation du capteur de la figure 9,
- la figure 13 est une illustration schématique d'une jauge résonante utilisée dans le mode de réalisation de la figure 12,
- la figure 19 est un organigramme d'un procédé de fonctionnement du capteur du mode de réalisation de la figure 18.

Dans ces figures, les mêmes références sont utilisées pour désigner les mêmes éléments. Dans la suite de cette description, les caractéristiques et fonctions bien connues de l'homme du métier ne sont pas décrites en détail.

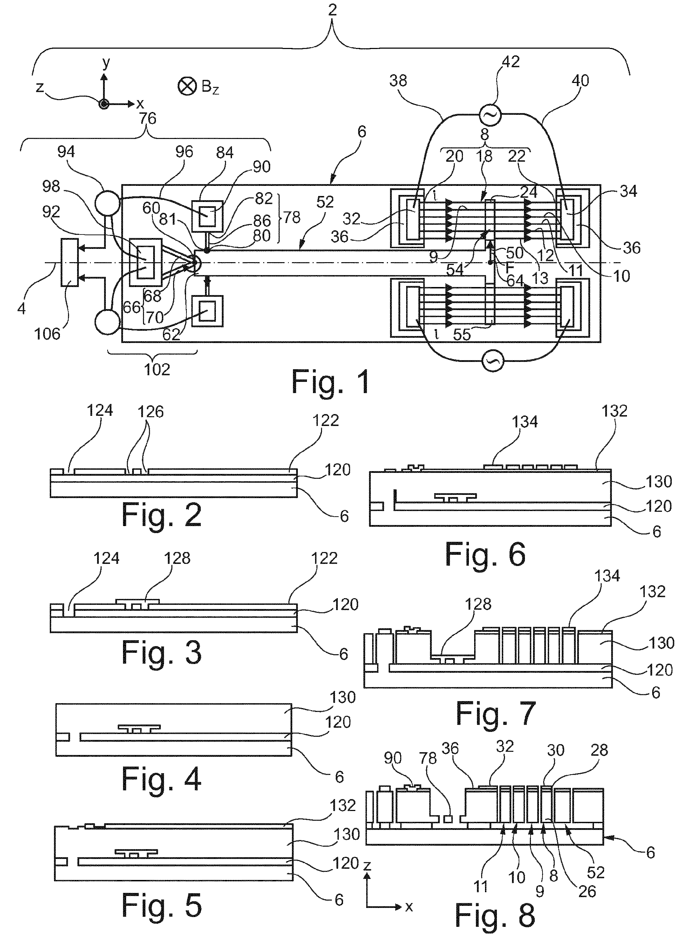

La figure 1 représente un capteur 2 de champ magnétique à force de Laplace. Plus précisément, ce capteur 2 est apte à mesurer l'amplitude d'une composante B_{Z} du champ magnétique. La composante B_{Z} est représentée par une croix située à l'intérieur d'un cercle. La composante B_{Z} est perpendiculaire au plan de la feuille et parallèle à un axe Z d'un repère orthogonal X, Y, Z. Les axes X et Y sont horizontaux.

Le capteur 2 est symétrique par rapport à un plan vertical 4 parallèle aux directions X et Z. Par conséquent, seuls les éléments du capteur 2 situés du côté supérieur de ce plan 4 sont décrits en détail.

Le capteur 2 comporte un substrat 6 qui s'étend essentiellement dans un plan horizontal appelé « Plan du substrat ». Typiquement, les dimensions de ce substrat 6 sont inférieures à 1 mm². Par exemple, sa longueur est inférieure à 1 mm ou 500 µm, et sa largeur est inférieure à 500 µm ou 300 µm.

Le substrat 6 est réalisé dans un matériau usinable par les techniques de la microélectronique, c'est-à-dire les mêmes techniques que celles utilisées pour réaliser des composants électroniques tels que des transistors. Par exemple, le substrat 6 est un substrat semi-conducteur tel que du Silicium.

Le capteur 2 comprend des conducteurs électriques 8 à 13. Ici, chacun de ces conducteurs 8 à 13 est rectiligne et s'étend parallèlement à la direction X. Dans ce mode de réalisation, les conducteurs 8 à 13 sont identiques les uns aux autres, et seul le conducteur 8 va maintenant être décrit plus en détail.

Le conducteur 8 comporte une partie mobile 18 située entre deux liaisons mécaniques 20 et 22. Les liaisons mécaniques 20 et 22 raccordent mécaniquement le conducteur 8 au substrat 6.

La partie mobile 18 est suspendue au-dessus du substrat. Ici, par « suspendu » on désigne un élément mécaniquement isolé du substrat, dans la direction Z, par un évidement dans lequel on fait le vide ou qui est rempli d'un gaz. Cet élément est donc apte à se déplacer par rapport au substrat.

La partie mobile 18 est destinée à se déplacer le long d'une direction de déplacement parallèle à la direction Y sous l'effet de la force de Laplace qui apparaît lorsque cette partie mobile est traversée par un courant i en présence de la composante B_{Z}. Typiquement, la force de l aplace qui s'exerce sur la partie mobile 18 est donnée par la relation suivante : *̅F̅*̅=*̅i̅d̅l̅*̅∧*B̅_{Z}* où :
- F est la force de Laplace qui s'exerce sur la partie mobile 18,
- i est l'intensité du courant qui circule dans le conducteur 8,
- dl est la longueur du conducteur 8,
- B_{Z} est la composante du champ magnétique à mesurer, et
- le symbole « A » est l'opération mathématique produit vectoriel.

Ici, le conducteur 8 est un barreau rectiligne de section verticale carrée ou rectangulaire. La section de ce barreau est telle que le barreau se déforme de façon élastique dans la direction Y ou dans la direction opposée quand il est soumis à une force de Laplace. Plus précisément, ici, ce barreau se courbe dans un plan horizontal.

L'amplitude maximum du déplacement de la partie mobile 18 se produit à mi-distance entre les liaisons 20 et 22, c'est-à-dire en un point milieu 24.

Dans ce mode de réalisation, le barreau est formé par l'empilement, en allant du bas vers le haut :
- d'une poutre 26 (figure 8) en matériau semi-conducteur,
- d'une couche 28 (figure 8) en matériau électriquement isolant,
- d'une couche 30 (figure 8) en matériau électriquement conducteur.

Ici, par matériau électriquement électriquement conducteur, on désigne un matériau dont la conductivité électrique est supérieure à 10⁵ ou 10⁶ S.m⁻¹ à 20°C.

La couche conductrice 30 s'étend sur les liaisons 20 et 22 pour raccorder électriquement le conducteur électrique 8 à des plots électriques 32 et 34 d'alimentation. Ces plots 32 et 34 sont également réalisés dans un matériau électriquement conducteur. Ainsi, les liaisons 20 et 22 assurent également le raccordement électrique du conducteur aux plots 32 et 34.

Ces plots 32 et 34 sont fixés sans aucun degré de liberté sur le substrat 6. Ils sont électriquement isolés de ce substrat 6 par une couche isolante 36 (figure 1 et figure 8).

Les plots 32 et 34 sont électriquement raccordés par l'intermédiaire de liaisons filaires, respectivement 38 et 40, à une source 42 de courant. Ici, cette source 42 est une source de courant alternatif.

Le point milieu 24 de chaque conducteur 8 à 13 est mécaniquement raccordé à un même point d'attache 50 d'un levier rigide 52 par l'intermédiaire d'une liaison mécanique 54. Ici, la liaison 54 est une poutrelle 55 rectiligne qui s'étend parallèlement à la direction Y et qui passe par chacun des points milieux 24 de chaque conducteur 8 à 13 jusqu'à atteindre le point d'attache 50. La poutrelle 55 est fixée, sans aucun degré de liberté dans l'axe de déplacement, à chacun des points milieux 24 et au point d'attache 50. Par exemple, la poutrelle 55 ne forme qu'un seul bloc de matière avec les poutres 26 des conducteurs électriques 8 à 13 et le levier 52.

Ainsi, la liaison 54 transforme tout déplacement du point milieu 24 parallèlement à la direction Y en un déplacement de même amplitude et de même direction du point d'attache 50.

A cet effet, la poutrelle 55 est suspendue au-dessus du substrat 6. Elle est maintenue suspendue par, d'un côté, les points milieux 24 et, de l'autre côté, le point d'attache 50. La poutrelle 55 se déplace uniquement en translation le long de la direction Y.

La poutrelle 55 et le levier 52 sont isolés électriquement des conducteurs 8 à 13 par la présence de la couche 28 en matériau isolant sur laquelle sont disposés les conducteurs électriques.

Le levier 52 permet d'amplifier la force de Laplace qui s'exerce sur les conducteurs 8 à 13 par un effet de bras de levier. A cet effet, le levier 52 est monté déplaçable en rotation autour d'un axe vertical 60 fixé sans aucun degré de liberté au substrat 6. Dans sa position de repos, représentée sur la figure 1, la plus grande longueur du levier 52 s'étend parallèlement à la direction X entre une extrémité proximale 62 et une extrémité distale 64. Le point d'attache 50 est situé au niveau de l'extrémité distale 64. L'axe 60 est situé au niveau de l'extrémité proximale 62. Le levier 52 s'étend ici dans le plan 4 de symétrie.

Le levier 52 est rectiligne. Il est suspendu au-dessus du substrat 6, au niveau de l'extrémité proximale 62, par une charnière 66 et, au niveau de l'extrémité distale 64, par la liaison 54.

Dans ce mode de réalisation, le levier 52 ne supporte aucun conducteur électrique sur lequel une force de Laplace pourrait s'exercer. Typiquement, la longueur du levier 52 est inférieure à 2 mm ou 500 µm et, généralement, supérieure à 50 µm ou 100 µm.

Le levier 52 est rigide. Ici par « rigide », on désigne le fait que sa section transversale et le matériau dans lequel il est réalisé ont été choisis de manière à ce que sa raideur en flexion, au niveau du point d'attache 50, dans la direction d'application de la force de Laplace à mesurer, est supérieure et, de préférence au moins dix ou cent fois supérieure, à la raideur en compression des poutres piézorésitives suspendues qui rattache également ce levier au substrat 6. Ces poutres piézorésistives sont décrites plus loin. La raideur en flexion est par exemple mesurée ou calculée en remplaçant la charnière par un ancrage de raideur infini et ne présentant aucun degré de liberté. Pour le levier 52, la direction d'application de la force de Laplace est parallèle à la direction Y.

La charnière 66 permet essentiellement la rotation du levier 52 autour de l'axe 60. Par exemple, la charnière 66 est formée par deux lames verticales 68 et 70 symétriques l'une de l'autre par rapport au plan 4. Ces deux lames se rejoignent au niveau de l'axe 60 et s'éloignent l'une de l'autre au fur et à mesure que l'on s'éloigne de l'axe 60 dans la direction X.

Le capteur 2 comprend une jauge 76 de contrainte utilisée pour mesurer le débattement angulaire du levier 52 autour de l'axe 60. Ici, cette jauge 76 comprend une poutre ou un fil 78 piézorésistif pour transformer le déplacement angulaire du levier 52 en une variation de résistance mesurable. Cette poutre 78 comporte :
- une partie 80 ancrée sans aucun degré de liberté dans le levier 52 en un point d'attache 81,
- une partie 82 ancrée sans aucun degré de liberté à une aspérité 84 du substrat 6, et
- une partie 86 suspendue au-dessus du substrat 6.

L'épaisseur de la poutre 78 est avantageusement au moins deux, cinq ou dix fois inférieure à l'épaisseur du levier 52 de manière à concentrer la contrainte exercée par le levier 52 à l'intérieur d'une surface réduite ce qui augmente la sensibilité du capteur 2. De préférence également, la section transversale de la poutre 78 est plusieurs fois inférieure à celle du levier 52 pour décroître sa raideur en traction-compression.

Par exemple, la poutre 78 est réalisée en Silicium ou en SiGe, alliage de silicium et de Germanium. Elle peut aussi être réalisée en métal. De façon plus générale, elle peut être réalisée dans tout matériau dont la sensibilité piézorésistive exprimée par le rapport (dR/R)/(dI/I) est égale ou supérieure à la sensibilité des matériaux précédemment cités, où :
- dR est la variation de résistance de la poutre 78,
- R est la résistance de la poutre 78 au repos, c'est-à-dire en absence de contrainte,
- dl est la variation de la longueur de la poutre 78 lorsqu'elle est soumise à une contrainte à mesurer,
- et la longueur au repos de la poutre 78.

Ici, la poutre 78 s'étend parallèlement à la direction Y.

Le point d'attache 81 se trouve aussi proche que possible de l'axe 60 pour bénéficier au maximum de l'effet d'amplification de la force de Laplace provoquée par le levier 52. A cet effet, la distance la plus courte entre le point d'attache 81 et l'axe 60 est inférieure à un dixième ou un cinquantième de la longueur du levier 52 dans la direction X. Par exemple, cette distance est inférieure à 5 ou 10 µm. Toutefois, le point d'attache 81 ne se situe pas sur l'axe 60 pour que l'effet d'amplification existe.

La jauge 76 comporte également deux plots électriques 90 et 92 et un ohmmètre 94. Par ohmmètre, on entend ici tout type de dispositif capable de mesurer une variation de résistance, directement ou indirectement. En pratique, on pourra par exemple utiliser une mesure de tension à travers un pont de Wheatstone. Les plots 90 et 92 sont directement électriquement raccordés, respectivement, aux parties 82 et 80 de la poutre 78. Ici, par directement, on désigne le fait que le raccordement ne passe pas par l'intermédiaire de la poutre 78 ou de l'ohmmètre 94.

Le plot 92 est raccordé électriquement à la partie 80 par l'intermédiaire des lames 68 et 70 et de l'extrémité proximale 62. A cet effet, les lames 68, 70 et l'extrémité proximale 62 peuvent être recouvertes d'un matériau électriquement conducteur.

L'ohmmètre 94 est électriquement raccordé aux plots 90 et 92 par l'intermédiaire de liaisons filaires, respectivement, 96 et 98. Cet ohmmètre 94 mesure la variation de résistance de la poutre 78 en réponse à la contrainte exercée sur elle par le levier 52 et génère un signal de mesure représentatif de la résistance mesurée.

Le capteur 2 comporte également une autre jauge 102 de contrainte qui comporte une poutre piézorésisitive symétrique de la poutre 78 par rapport au plan 4. La jauge 102 mesure un déplacement de même amplitude que la jauge 76 mais de direction opposée.

Les jauges 76 et 102 sont raccordées à une unité électronique 106 de traitement. L'unité 106 est programmée pour calculer l'amplitude de la composante B_{Z} en fonction des signaux de mesure délivrés par les jauges 76 et 102.

La fréquence de résonance f_{R} du capteur 2 est essentiellement fixée par le levier 52, la charnière 66 et des poutres 78. Ici, les dimensions du levier 52 et de la charnière 66 sont choisies pour que la fréquence f_{R} soit supérieure à 1 kHz et, de préférence, supérieure à 10 kHz. Grâce à l'architecture du capteur 2, il n'est pas nécessaire de modifier les conducteurs électriques 8 à 13 pour fixer cette fréquence f_{R}.

Le fonctionnement du capteur 2 est le suivant. La source 42 génère un courant alternatif à la fréquence f_{A}, égale, avantageusement, à la fréquence de résonance f_{R}. La force de Laplace s'exerce sur les conducteurs 8 à 13 tantôt dans la direction Y, tantôt dans la direction opposée. Cela excite le capteur 2 à cette fréquence f_{A}. Le levier 52 oscille alors autour de l'axe 60. L'amplitude angulaire de ces oscillations est représentative de la force de Laplace qui s'exerce et donc de l'amplitude de la composante Bz. Les jauges 76 et 102 génèrent des signaux de mesure représentatifs de l'amplitude du débattement angulaire du levier 52 et transmettent ces signaux à l'unité 106. L'unité 106 calcule l'amplitude de la composante Bz du champ magnétique à partir de ces signaux.

Les figures 2 à 8 représentent différentes étapes successives de fabrication du capteur 2. Les figures 2 à 8 sont des vues en coupe verticale de différents éléments du capteur 2. Ces différents éléments ont été juxtaposés dans ces vues, même s'ils ne sont pas l'un à côté de l'autre dans le capteur 2. Ainsi, ces vues ne correspondent pas à une coupe du capteur 2 selon un plan de coupe mais illustrent simplement la fabrication des différents éléments sans tenir compte de leur agencement les uns par rapport aux autres dans le capteur 2.

La fabrication débute par la fourniture d'un substrat SOI (Silicon-On-Insulator). Ce substrat comporte le substrat 6, une couche 120 (Figure 2) en matériau électriquement isolant tel que de l'oxyde de silicium et une couche 122 (Figure 2) de silicium. Par exemple, les couches 120 et 122 ont respectivement des épaisseurs égales à 1 µm et 0,3 µm.

Ensuite, la couche 122 est gravée par photolithographie de manière à former un trou 124 et deux trous 126 (Figure 2). Le trou 124 est utilisé pour la réalisation d'un plot de contact électrique avec le substrat 6. Les deux trous 126 sont utilisés pour la réalisation de la poutre piézorésistive 78 de la jauge 76.

Ensuite, une couche d'oxyde 128 (Figure 3) est déposée sur la couche 122. Par exemple, l'épaisseur de la couche 128 est de 0,3 µm.

La couche 128 est gravée à l'aide d'un procédé photo-lithographique pour ne laisser subsister que les parties de la couche 128 qui remplissent et recouvrent les deux trous 126. Lors de ces étapes de gravure, la couche d'oxyde au fond du trou 124 est également supprimée pour laisser le substrat 6 exposé à l'extérieur.

Ensuite, une couche 130 (figure 4) de Silicium est déposée sur la couche 128. Par exemple, cette couche 130 est déposée par croissance épitaxiale sur la couche 122 et sur les restes de la couche 128. Cette couche 130 ne forme qu'une seule et même couche avec la couche 122 de sorte que seule la couche 130 a été représentée. L'épaisseur de la couche 130 est d'environ 20 µm.

Une couche 132 (figure 5) en matériau électriquement isolant est ensuite déposée sur la couche 130. Cette couche 132 est ensuite gravée par photolithographie aux emplacements où la formation d'un contact électrique direct avec la couche 130 est nécessaire. Par exemple, la couche 132 est une couche en nitrure de Silicium de 0,1 µm d'épaisseur.

Une couche 134 (figure 6) en matériau électriquement conducteur est ensuite déposée sur la couche 132. Par exemple, la couche 134 est une couche métallique. Cette couche 134 est ensuite gravée pour former les différents plots et pistes électriques du capteur 2.

Ensuite, la couche 132 est gravée (figure 7) par photoligraphie. La couche 130 est également gravée en utilisant le même masque de résine et les couches d'oxyde 120 et 128 comme couche d'arrêt. Par exemple, la couche 130 est gravée à l'aide du procédé de gravure DRIE (Deep Reactive Ion Etching).

Enfin, les couches d'oxyde 120 et 128 sont retirées (figure 8) pour libérer les différentes parties mobiles du capteur 2.

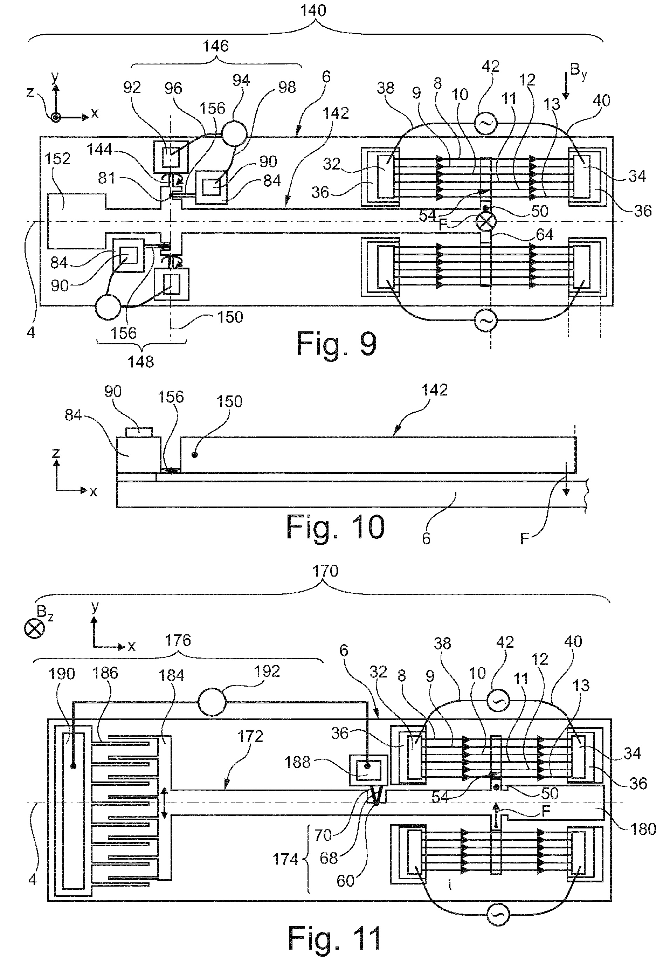

La figure 9 représente un capteur 140 d'une composante B_{Y} d'un champ magnétique à mesurer. La composante B_{Y} est ici parallèle à la direction Y. Ce capteur 140 est identique au capteur 2, sauf que :
- le levier 52 est remplacé par un levier 142,
- la charnière 66 est remplacée par une charnière 144,
- les jauges 76 et 102 sont remplacées par des jauges 146 et 148.

Pour simplifier cette figure et les figures suivantes, l'unité de traitement 106 n'a pas été représentée.

Le levier 142 est identique au levier 52 sauf qu'il est uniquement déplaçable en rotation autour d'un axe de rotation 150 horizontale parallèle à la direction Y. De plus, le levier 142 comporte un contrepoids 152. Le contrepoids 152 ne forme qu'un seul bloc de matière avec le reste du levier 142. Par conséquent, ce contrepoids 152 se déplace en rotation autour de l'axe 150.

Le poids et les dimensions du contrepoids 152 sont choisis pour que le centre de gravité du levier 142 soit à une distance d de l'axe 150 de rotation. Ici, la distance d est inférieure à 1 % ou 0,5 % de la longueur, selon la direction X, du levier 142. Par exemple, ces dimensions sont telles que le centre de gravité du levier 142 est sur l'axe 150, c'est-à-dire que la distance d est inférieure à 0,1 % ou 0,05 % de la longueur du levier 142. Un tel positionnement du centre de gravité par rapport à l'axe de rotation 150 permet d'accroître l'insensibilité du capteur 140 aux accélérations et vibrations mécaniques selon la direction Z.

La charnière 144 permet :
- uniquement le déplacement en rotation du levier 142 autour de l'axe 150, et
- le maintient le levier 142 suspendu au-dessus du substrat 6.

Par exemple, la charnière 144 est formée d'une première poutre suspendue s'étendant le long de l'axe 150 et dont les extrémités sont ancrées, sans aucun degré de liberté, d'un côté directement sur le levier 142 et de l'autre côté sur le substrat 6. La section transversale de cette poutre est telle qu'elle est déformable en torsion autour de l'axe 150. Ici, la charnière 144 comporte également une deuxième poutre symétrie de la première poutre par rapport au plan 4 et située de l'autre côté de ce plan 4.

La jauge 146 est identique à la jauge 76 sauf que la poutre piézorésistive 78 est remplacée par une poutre piézorésistive 156. La poutre 156 est identique à la poutre 78, sauf qu'elle s'étend parallèlement à la direction X pour mesurer l'angle de débattement du levier 142 autour de l'axe 150.

La jauge 148 est identique à la jauge 146 mais sa poutre 156 est positionnée pour mesurer un débattement angulaire de même amplitude mais de signe opposé à celui mesuré par la jauge 146.

La figure 10 est une vue en coupe de la poutre 156 de la jauge 148. L'épaisseur de la poutre 156 est deux, cinq ou dix fois inférieure à l'épaisseur du levier 142. Cela permet d'accroître la sensibilité du capteur 140 car la contrainte se concentre dans une section transversale beaucoup plus petite.

Le fonctionnement du capteur 140 et des capteurs suivants se déduit du fonctionnement décrit dans le cas du capteur 2.

La figure 11 représente un capteur 170 de la composante B_{Z} du champ magnétique. Ce capteur 170 est identique au capteur 2 sauf que :
- le levier 52 est remplacé par un levier 172,
- la charnière 66 est remplacée par une charnière 174,
- les jauges de contrainte 76 et 102 sont remplacées par une jauge capacitive 176.

Le levier 172 est identique au levier 52 sauf qu'il comporte en plus un contrepoids 180 pour que son centre de gravité soit à une distance d de l'axe de rotation 60. Comme pour le capteur 140, le poids et les dimensions du contrepoids 180 sont choisis pour que la distance d soit inférieure à 1 % ou 0,5 % et, de préférence à 0,1 % ou 0,05 %, de la longueur du levier 172 dans la direction X.

La charnière 174 est identique à la charnière 66 sauf qu'elle est tournée de 90° autour d'un axe vertical par rapport à la position de la charnière 66 dans la figure 1. De plus, elle est située dans ce mode de réalisation plus proche du point d'attache 50 que de l'extrémité du levier 172 où se situe la jauge 176. Ainsi, dans ce mode de réalisation, le levier 172 est utilisé pour amplifier le débattement angulaire provoqué par la force de Laplace. Cela permet d'augmenter la sensibilité du capteur 170.

La jauge 176 comporte une armature mobile 184 et une armature fixe 186. L'armature 184 est fixée sans aucun degré de liberté à une extrémité du levier 172 la plus éloignée possible du point d'attache 50. Ici, l'armature 184 est située de l'autre côté de l'axe 60 par rapport au côté où se trouve le point 50.

L'armature 186 est fixée sans aucun degré de liberté au substrat 6 en vis-à-vis de l'armature 184 pour former un condensateur. Ici, les armatures 184 et 186 sont inter-digitées de manière à augmenter la surface des faces de ces armatures en vis-à-vis.

Les armatures 184 et 186 sont raccordées électriquement à des plots électriques, respectivement, 188 et 190. Les plots 188 et 190 sont électriquement raccordés à des bornes respectives d'un capacimètre 192. Le capacimètre 192 génère un signal de mesure représentatif de l'amplitude du débattement angulaire du levier 172 et transmet ce signal à l'unité 106 de traitement.

Quand la force de Laplace déplace en rotation le levier 172, cela modifie la capacité entre les armatures 184 et 186. Cette modification de capacité est mesurée par le capacimètre 192 et transmise à l'unité 106 de traitement. L'unité 106 calcule alors l'amplitude de la composante Bz à partir de ce signal de mesure.

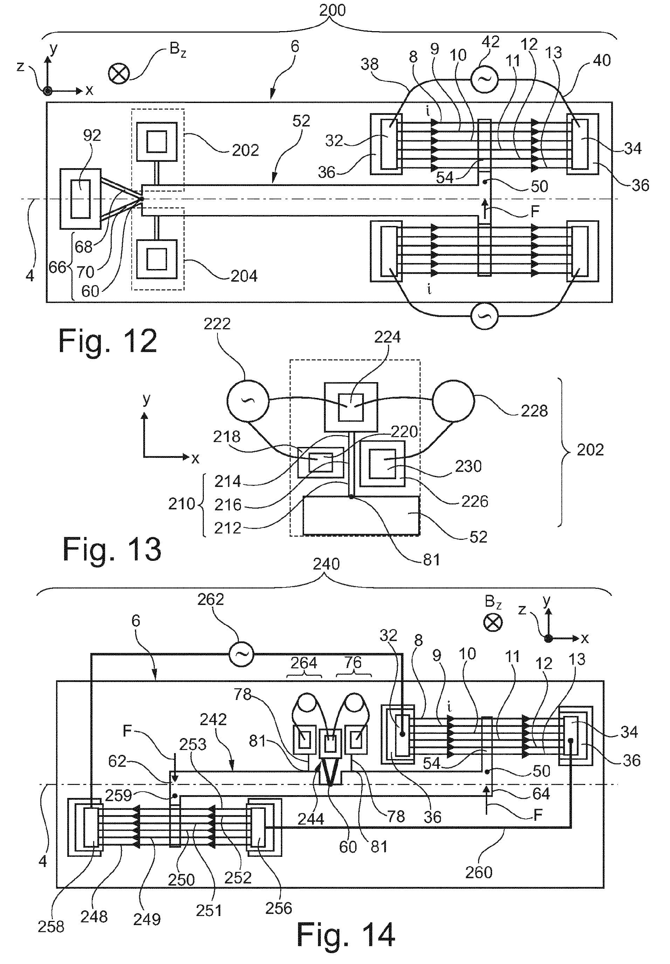

La figure 12 représente un capteur 200 identique au capteur 2, sauf que les jauges 76 et 102 sont, respectivement, remplacées par des jauges résonantes 202 et 204. Les jauges 202 et 204 sont identiques l'une à l'autre sauf qu'elles mesurent chacune une contrainte de même amplitude que celle mesurée par l'autre jauge mais de signe opposé. Ainsi, seule la jauge 202 est décrite plus en détail en référence à la figure 13.

La jauge 202 comporte une poutre 210 suspendue au-dessus du substrat 6. Une partie 212 de cette poutre est ancrée, sans aucun degré de liberté dans l'axe de la poutre, au levier 52 au niveau du point d'attache 81. Une autre partie 214 de cette poutre est ancrée sans aucun degré de liberté au substrat. Une partie mobile 216 de cette poutre est située entre les parties 212 et 214. Cette partie mobile 216 est suspendue au-dessus du substrat 6 de manière à pouvoir vibrer. Typiquement, la poutre 210 est réalisée en matériau semi-conducteur ou conducteur. Ici, elle est réalisée en Silicium.

La jauge 202 comporte également une électrode d'actionnement 218 placée à proximité de la partie mobile 216 pour exercer sur cette partie mobile une force électrostatique qui l'attire et, en alternance, la repousse dans la direction X. Pour faire vibrer la partie centrale, l'électrode 218 est raccordée électriquement via un plot électrique 220 à une borne d'une source 222 de tension alternative. La tension alternative est générée à une fréquence f₀. Une autre borne de la source 222 est directement raccordée à la partie 214 de la poutre 210 par l'intermédiaire d'un plot électrique 224. Ainsi, en absence de contrainte, la poutre 210 vibre à une fréquence f₀.

La jauge 202 comporte également une électrode 226 de mesure disposée en vis-à-vis de la partie mobile 216 pour former avec la partie mobile un condensateur dont la capacité varie en fonction du déplacement de la partie mobile 216. L'électrode 226 est électriquement raccordée à une borne d'un capacimètre 228 par l'intermédiaire d'un plot électrique 230. L'autre borne du capacimètre 228 est raccordée au plot 224. Ainsi, le capacimètre 228 permet de mesurer la fréquence de vibration fv de la partie mobile 216. La fréquence fv varie en fonction de la contrainte exercée par le levier 52 sur la poutre 210. Cette variation de la fréquence f_{V} permet de mesurer l'amplitude du débattement angulaire du levier 52 et donc l'amplitude de la composante Bz du champ magnétique.

La figure 14 représente un capteur 240 identique au capteur 2 sauf que les différentes parties mobiles du capteur sont disposées de façon symétrique par rapport à l'axe 60 de rotation du levier. Cela permet de décroître la sensibilité du capteur aux accélérations et vibrations mécaniques selon la direction Y. A cet effet, le levier 52 est remplacé par un levier 242 et la charnière 66 est remplacée par une charnière 244.

Le levier 242 est identique au levier 52 mais disposé de façon symétrique par rapport à l'axe 60 de rotation.

La charnière 244 est identique à la charnière 66 mais tournée de 90° dans le plan du substrat par rapport à la position de la charnière 66 dans la figure 1.

La partie moteur, symétrique de la partie moteur comportant les conducteurs 8 à 13 et les plots 32 à 34 par rapport au plan 4, est remplacée par une partie moteur disposée de façon symétrique mais par rapport, cette-fois, à l'axe 60 de rotation. Les conducteurs électriques symétriques des conducteurs 8 à 13 par rapport à l'axe 60 portent ici, respectivement, les références 248 à 253. Les plots électriques symétriques des plots 32 à 34 portent les références, respectivement, 256 et 258. Le point d'attache symétrique du point d'attache 50 porte la référence 259.

De manière à ce que le courant i circule dans un sens dans les conducteurs 8 à 13 et dans le sens opposé dans les conducteurs 248 à 253, les plots 34 et 256 sont directement raccordés électriquement l'un à l'autre via une liaison électrique 260, et les plots 32 et 258 sont électriquement raccordés chacun à une borne respective d'une source 262 de courant alternatif.

La jauge 102 est remplacée par une jauge 264. La jauge 264 est identique à la jauge 102, sauf que sa poutre 78 est placée de façon symétrique à la poutre 78 de la jauge 76 par rapport à un plan vertical passant par l'axe 60 et perpendiculaire à la direction X.

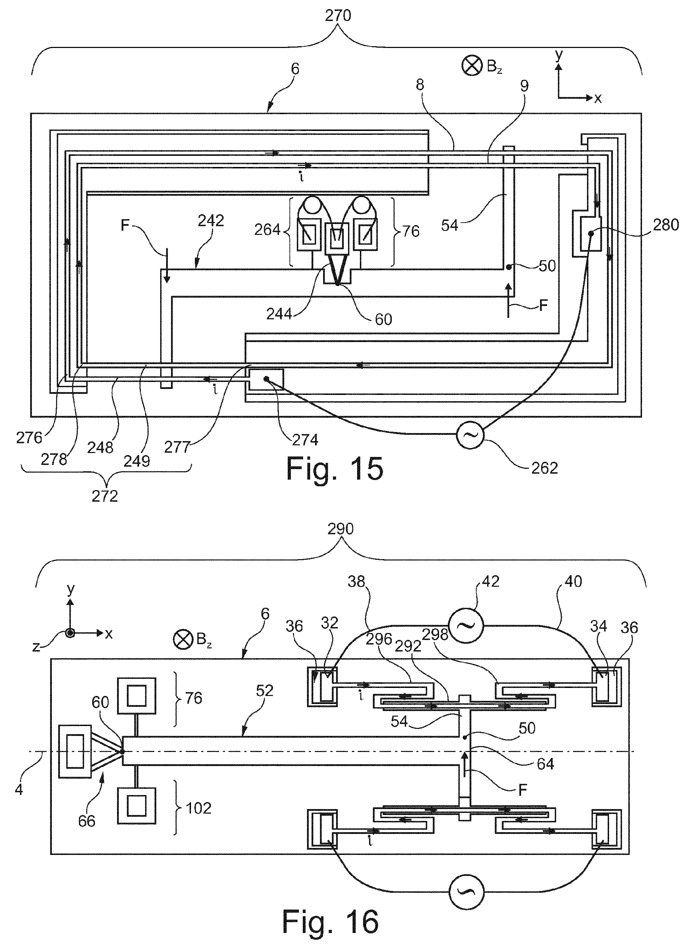

La figure 15 représente un capteur 270 identique au capteur 240, sauf que les conducteurs 8 à 13 et 248 à 253 sont électriquement raccordés les uns aux autres de manière à former une bobine 272.

Ici, pour simplifier l'illustration de la bobine 272, celle-ci est décrite dans le cas où seuls les conducteurs 8, 9, 248 et 249 existent.

L'extrémité droite du conducteur 248 est directement électriquement raccordée à un plot électrique 274. L'extrémité gauche de ce conducteur 248 est raccordée électriquement à l'extrémité gauche du conducteur 8 par l'intermédiaire d'une piste électrique 276. L'extrémité droite du conducteur 8 est électriquement raccordée à l'extrémité droite du conducteur 249 par l'intermédiaire d'une piste électrique 277. L'extrémité gauche du conducteur 249 est électriquement raccordée à l'extrémité gauche du conducteur 9 par l'intermédiaire d'une piste électrique 278. L'extrémité droite du conducteur 9 est directement raccordée à un plot électrique 280. Ainsi, la bobine 272 comporte deux spires dont la deuxième n'est que partiellement complète. Les plots 274 et 280 ainsi que les pistes 276 à 278 sont fixés sans aucun degré de liberté sur le substrat

Une source 262 de courant électrique est raccordée entre les plots 274 et 280 pour faire circuler le courant i dans les conducteurs 8 et 9, 248 et 249.

La figure 16 représente un capteur 290 identique au capteur 2 sauf que les conducteurs 8 à 13 sont remplacés par un conducteur électrique 292.

Le conducteur 292 est rigide, c'est-à-dire qu'il ne se déforme pas dans la direction Y lors de l'utilisation du capteur 290 pour mesurer la composante B_{Z} du champ magnétique. Les extrémités du conducteur électrique 292 sont raccordées par l'intermédiaire de liaisons mécaniques, respectivement 296 et 298, au substrat 6. Ces liaisons 296 et 298 raccordent également électriquement le conducteur électrique 292 aux plots 32 et 34. Ici, ces liaisons 296 et 298 sont aptes :
- à se déformer dans la direction Y pour permettre le déplacement, dans la direction Y, du conducteur 292 sous l'effet de la force de Laplace, et
- à maintenir le conducteur 292 suspendu au-dessus du substrat 6.

A cet effet, la raideur des liaisons 296 et 298 dans la direction Y est au moins 5 à 50 fois inférieure à la raideur de ces mêmes liaisons dans la direction Z. Par exemple, pour cela, chaque liaison 296 et 298 est conformée en méandre, c'est-à-dire qu'elle forme chacune un serpentin qui zigzague en avançant dans la direction Y. Une extrémité de chaque liaison 296, 298 est raccordée sans aucun degré de liberté au substrat 6, tandis que l'autre extrémité est raccordée sans aucun degré de liberté à une extrémité respective du conducteur 292. Le fait d'utiliser des liaisons mécaniques flexibles dans la direction Y permet d'augmenter l'amplitude du déplacement du conducteur 292 et donc la sensibilité du capteur 290. Cela permet aussi de faciliter l'optimisation des dimensions du conducteur 292.

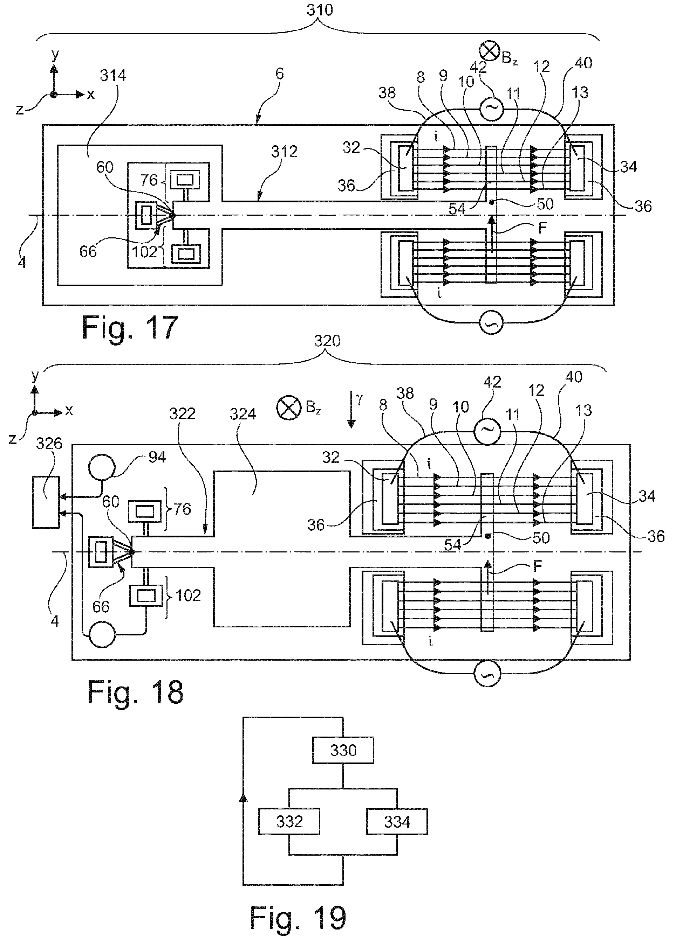

La figure 17 représente un capteur 310 identique au capteur 2 sauf que le levier 52 est remplacé par un levier 312. Le levier 312 est identique au levier 52, sauf qu'il comporte en plus un contrepoids 314. Le contrepoids 314 est conformé de façon similaire à ce qui a été décrit pour le contrepoids 180 afin de réduire la sensibilité du capteur aux accélérations et vibrations mécaniques selon la direction Y.

La figure 18 représente un capteur 320 identique au capteur 2, sauf que le levier 52 est remplacé par un levier 322. Le levier 322 est identique au levier 52 mais comporte en plus une masselotte 324 qui éloigne le centre de gravité du levier 322 de l'axe 60 de rotation. Par exemple, la distance la plus courte entre le centre de gravité du levier 322 et l'axe 60 est supérieure à 10 ou 30 % de la longueur du levier 322 dans la direction X. Cette masselotte 324 augmente aussi la sensibilité du levier 322 à l'accélération dans la direction Y.

Dans ce mode de réalisation, l'unité de traitement 106 est également remplacée par une unité de traitement 326 capable de mesurer simultanément, en plus de l'amplitude de la composante B_{Z}, la composante a_{Y} de l'accélération parallèle à la direction Y.

Le fonctionnement du capteur 320 va maintenant être décrit plus en détail à l'aide du procédé de la figure 19.

Lors d'une étape 330, la source de courant 42 génère un courant alternatif à une fréquence f_{A}, correspondant avantageusement à la fréquence f_{R}, très supérieure à la fréquence de la composante ay de l'accélération à mesurer. Par exemple, la fréquence f_{R} est supérieure à 1 ou 2 ou 10 kHz. Ici, la fréquence f_{A} est choisie égale à 20 kHz.

Ensuite, lors d'une étape 332, l'unité de traitement 326 acquiert les signaux de mesure générés par les jauges 76 et 102. Lors de cette étape 332, l'unité 326 filtre ces signaux de mesure pour conserver la composante autour de la fréquence f_{A} en tenant compte du facteur de qualité. Typiquement, le ou les composantes conservées sont uniquement celles dont la fréquence est comprise à l'intérieur de la largeur à -3dB du pic de résonance centré sur la fréquence f_{A} dans la densité spectrale de puissance du signal acquis. Ensuite, l'amplitude de la composante B_{Z} est uniquement déterminée à partir des composantes des signaux de mesure ayant une fréquence autour de cette fréquence f_{A}.

En parallèle, lors d'une étape 334, l'unité de traitement 326 filtre les signaux de mesure pour en exclure les composantes ayant une fréquence supérieure à la bande passante de l'accéléromètre. La bande passante de l'accéléromètre est typiquement inférieure à 2kHz ou 1 kHz et, souvent, inférieure à 100Hz. Par exemple, seules les composantes du signal dont les fréquences sont inférieures à quatre fois la fréquence f_{A} sont conservées. Ensuite, lors de cette étape 334, l'unité 326 détermine l'amplitude de la composante a_{Y} uniquement à partir des composantes conservées par ce filtrage.

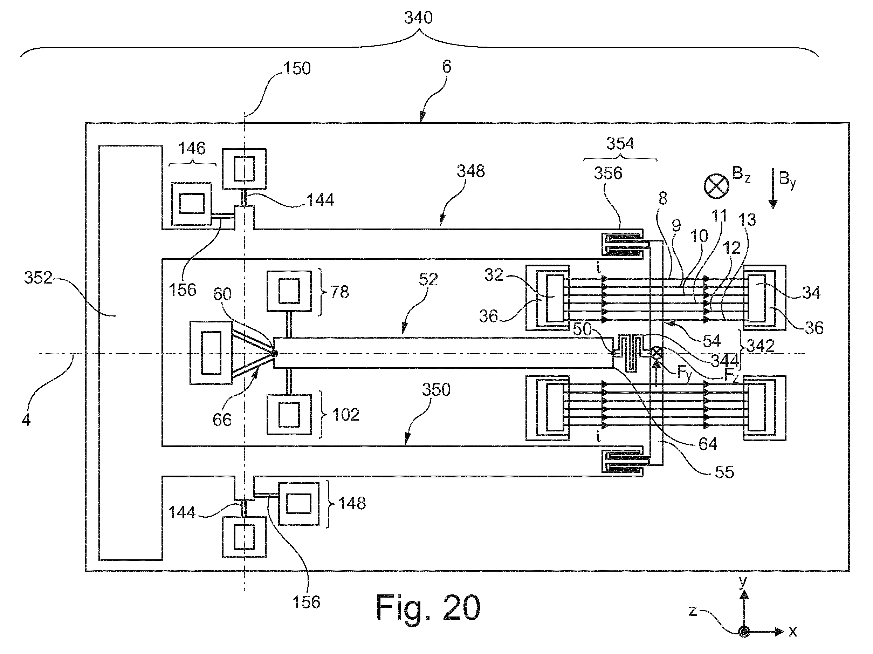

La figure 20 représente un capteur 340 capable de mesurer à la fois les composantes B_{Z} et B_{Y} du champ magnétique. A cet effet, le capteur 340 combine des caractéristiques des capteurs 2 et 140.

Plus précisément, le capteur 340 comporte un capteur de l'amplitude de la composante Bz identique au capteur 2, sauf que la liaison 54 est remplacée par une liaison 342. La liaison 342 comporte la poutrelle 55 ainsi qu'une liaison supplémentaire 344 raccordant mécaniquement cette poutrelle 55 à l'extrémité distale 64 du levier 52. Cette liaison 344 est conformée en méandre de façon similaire à ce qui a été décrit pour les liaisons mécaniques 296 et 298 de la figure 16. Plus précisément, ici, cette liaison 344 est conformée pour que sa raideur dans la direction Y soit au moins 5 à 50 fois supérieure à sa raideur dans la direction Z. A cet effet, la liaison 344 zigzague en avançant dans la direction X.

Le capteur 340 comporte également un capteur de l'amplitude de la composante B_{Y} identique au capteur 140, sauf que le levier 142 est remplacé par deux leviers rigides identiques 348 et 358 montés en rotation autour de l'axe 150. De plus, ces leviers 348 et 358 comportent, à la place du contrepoids 152, un contrepoids 352 commun pour décroître la sensibilité du capteur aux accélérations ou aux vibrations mécaniques parallèles à la direction Z.

Les leviers 348 et 350 sont symétriques l'un de l'autre par rapport au plan 4. Ainsi, seul le raccordement du levier 348 aux conducteurs électriques 8 à 13 est maintenant décrit. Pour cela, la liaison 54 est remplacée par une liaison 354. La liaison 354 comporte la poutrelle 55 et en plus une liaison 356 conformée en méandre comme la liaison 344. Plus précisément, la liaison 356 est conformée en méandre pour que sa raideur dans la direction Z soit au moins 5 à 50 fois supérieure à sa raideur dans la direction Y. A cet effet, elle zigzague en avançant dans la direction Y et non pas dans la direction X.

De nombreux autres modes de réalisation sont possibles. Par exemple, comme illustré par les figures 1 et 20, le capteur de champ magnétique peut comporter un ou plusieurs axes de mesure. Ainsi, le capteur peut être mono-axe ou multiaxes.

Pour augmenter la précision, chacun des capteurs précédemment décrit peut être enfermé dans un caisson à l'intérieur duquel est réalisé le vide. Cela permet notamment d'accroître le facteur de qualité du système mécanique. Toutefois, selon les applications et la sensibilité souhaitée, cela n'est pas forcément nécessaire.

Quel que soit le mode de réalisation concerné, il est possible de n'utiliser qu'un seul conducteur électrique ou, au contraire, plusieurs conducteurs électriques en parallèle. De plus, ces conducteurs électriques peuvent être raccordés les uns aux autres de manière à former une bobine telle que décrite en référence à la figure 15.

Le courant qui circule dans les conducteurs électriques n'est pas nécessairement alternatif. En variante, il s'agit d'un courant variant en fonction du temps de façon non sinusoïdale ou d'un courant continu qui ne change jamais de signe.

Quel que soit le mode de réalisation, le contrepoids peut être omis si cela n'est pas nécessaire. De même, la masselotte utilisée pour augmenter la sensibilité du capteur aux accélérations peut être omise. En effet, tous les leviers sont sensibles à l'accélération à des degrés diverses.

En variante, un ou plusieurs conducteurs sensibles à la force de Laplace sont également fixés sur le levier.

De même, il n'est pas nécessaire que les jauges qui mesurent l'amplitude du débattement angulaire du levier soient montées en différentiel. Ainsi, dans une variante simplifiée, le capteur ne comporte qu'une seule jauge pour mesurer le débattement angulaire du levier.

Le conducteur électrique peut également être réalisé sous la forme d'une poutre en matériau semi-conducteur suffisamment dopée pour être rendue conductrice. Cela évite dans ce cas de déposer une couche en matériau électriquement conducteur sur une poutre en matériau semi-conducteur.

Dans les modes de réalisation précédents, les conducteurs électriques s'étendent parallèlement à l'axe longitudinal du levier. Toutefois, cela n'est pas forcément nécessaire lorsque la force de Laplace à mesurer est pérpendiculaire au plan du substrat. Ainsi, en variante, les conducteurs électriques s'étendent perpendiculairement à l'axe longitudinal du levier.

Pour augmenter la sensibilité du capteur, plusieurs leviers et plusieurs jauges peuvent être montés en parallèle les uns aux autres pour mesurer la même composante du champ magnétique.

Lorsqu'une jauge résonnante est utilisée, une seule et même électrode peut être utilisée à la fois pour faire résonner la poutre et pour mesurer la fréquence de vibration de cette poutre.

## Revendications

1. Capteur de champ magnétique à force de Laplace, ce capteur comportant :
- un substrat (6) s'étendant essentiellement dans un plan appelé plan du substrat,
- au moins un conducteur électrique (8-13 ; 248-253 ; 292) apte à être parcouru par un courant électrique, ce conducteur électrique comportant une partie mobile (18; 292), suspendue au-dessus du substrat, apte à se déplacer dans une direction de déplacement lorsqu'elle est soumise à une force de Laplace,
- des liaisons mécaniques (20, 22 ; 296, 298) raccordant mécaniquement cette partie mobile au substrat et raccordant électriquement la partie mobile à des plots d'alimentation en courant disposés sur le substrat,
- au moins une jauge (76, 102 ; 146, 148 ; 176 ; 202, 204 ; 264) apte à mesurer une grandeur physique représentative de l'amplitude du déplacement de la partie mobile, cette jauge comportant au moins une première et une seconde parties (80, 82),
- un levier (52 ; 142 ; 172 ; 242 ; 312 ; 322 ; 348, 350) suspendu déplaçable en rotation autour d'un axe (60 ; 150) de rotation perpendiculaire à la direction de déplacement de la partie mobile, ce levier comportant un premier et un second points d'attache (50, 81) distincts, le premier point d'attache (50) étant mécaniquement raccordé à la partie mobile pour transmettre au levier le déplacement de la partie mobile de manière à entraîner le levier en rotation autour de l'axe de rotation en réponse à un déplacement de la partie mobile, et le second point d'attache (81) étant directement mécaniquement raccordé à la première partie de la jauge,
**caractérisé en ce que** :
- le capteur comporte également une charnière (66 ; 144 ; 174 ; 244) raccordant mécaniquement le levier au substrat, cette charnière étant distincte et séparée des liaisons mécaniques de la partie mobile et des premier et second points d'attache, cette charnière permettant la rotation du levier autour de son axe de rotation, et
- le levier est rigide pour permettre un effet de bras de levier, et
- la seconde partie de la jauge est fixée sans aucun degré de liberté au substrat.

2. Capteur selon la revendication 1, dans lequel le second point d'attache (81) est plus près de l'axe (60 ; 150) de rotation du levier que le premier point d'attache (50), et la distance la plus courte entre ce second point d'attache et l'axe de rotation est inférieure à un dixième de la longueur du levier.

3. Capteur selon la revendication 1 ou 2, dans lequel la jauge (76, 102 ;146, 148 ; 264) est une jauge de contrainte suspendue, comportant en plus des première et deuxième parties, une troisième partie (86), disposée entre les première et seconde parties, suspendue au-dessus du substrat.

4. Capteur selon la revendication 3, dans lequel l'épaisseur de la troisième partie (86) est au moins deux fois inférieure à l'épaisseur du levier.

5. Capteur selon la revendication 1, dans lequel la jauge (176) comporte deux armatures (184, 186) en vis-à-vis formant une capacité, l'une de ces armatures étant solidaire du substrat, tandis que l'autre de ces armatures est mécaniquement raccordée au second point d'attache (81) du levier de manière à se déplacer par rapport à l'autre armature en réponse à un déplacement du levier.

6. Capteur selon la revendication 1 ou 2, dans lequel la jauge (202, 204) est une jauge résonante comportant :
- au moins une poutre (210) suspendue entre le second point d'attache et le substrat,
- une électrode (218) apte à faire vibrer la poutre,
- une autre électrode (226) ou la même électrode pour mesurer la fréquence de vibration de la poutre.

7. Capteur selon l'une quelconque des revendications précédentes, dans lequel le capteur comporte au moins deux jauges (76, 102 ; 146, 148 ; 202, 204 ; 264) disposées de manière à mesurer chacune un déplacement du levier, de signes opposés, au déplacement mesuré par l'autre jauge.

8. Capteur selon l'une quelconque des revendications précédentes, dans lequel le poids du levier est réparti de part et d'autre de son axe de rotation de manière à ce que la distance la plus courte entre l'axe (60 ; 150) de rotation du levier et le centre de gravité du levier soit inférieure à 1 % de la longueur du levier.

9. Capteur selon la revendication 8, dans lequel :
- le capteur comporte au moins un premier et un second exemplaires (8-13) dudit au moins un conducteur électrique, et
- l'axe (60) de rotation du levier est situé au milieu du levier dans le sens de sa longueur,
- le premier point d'attache (50) est mécaniquement raccordé au premier exemplaire dudit au moins un conducteur, et
- le levier comporte un troisième point d'attache (259) mécaniquement raccordé au second exemplaire (248-253) dudit au moins un conducteur électrique, ces premier et troisième points d'attache étant symétriques l'un de l'autre par rapport à l'axe de rotation.

10. Capteur selon l'une quelconque des revendications précédentes, dans lequel :
- le conducteur électrique (292) est rigide de manière à ne pas se déformer sous l'action de la force de Laplace, et
- les liaisons mécaniques (296, 298) sont conformées en méandre pour permettre au conducteur électrique de se déplacer lorsqu'il est soumis à la même force de Laplace.

11. Capteur selon l'une quelconque des revendications précédentes, dans lequel la partie mobile est mécaniquement raccordée au premier point d'attache (50) du levier par l'intermédiaire d'une liaison mécanique (344, 356) en forme de méandre agencée de manière à ce que la raideur de cette liaison mécanique dans la direction de déplacement de la partie mobile soit au moins cinq fois supérieure à sa raideur dans une direction orthogonale à cette direction de déplacement.

12. Capteur selon l'une quelconque des revendications précédentes, dans lequel le capteur comporte plusieurs conducteurs électriques (8-13 ; 248-253) disposés parallèlement les uns aux autres.

13. Procédé d'utilisation d'un capteur conforme à l'une quelconque des revendications précédentes, ce procédé comportant :
- l'alimentation (330) du conducteur électrique avec un courant alternatif de fréquence fondamentale f_{A},
- l'acquisition du signal représentatif de l'amplitude du déplacement de la partie mobile,
**caractérisé en ce que** le procédé comporte également :
- la détermination (332) de la mesure du champ magnétique uniquement à partir des composantes du signal de mesure acquis ayant une fréquence comprise à l'intérieur de la largeur à -3dB du pic de résonance centré sur la fréquence f_{A} dans la densité spectrale de puissance du signal acquis,
- la détermination (334) d'une mesure d'une accélération dans la direction de déplacement du conducteur électrique uniquement à partir des composantes du même signal de mesure acquis ayant une fréquence au moins quatre fois inférieure à la fréquence f_{A}.

## Patentansprüche

1. Sensor für Magnetfelder mit Laplace-Kraft, wobei dieser Sensor Folgendes aufweist:
- ein Substrat (6), das sich im Wesentlichen in einer Ebene, die Ebene des Substrats genannt wird, erstreckt,
- mindestens einen elektrischen Leiter (8-13; 248-253; 292), der geeignet ist, von einem elektrischen Strom durchflossen zu werden, wobei dieser elektrische Leiter einen beweglichen Teil (18; 292) aufweist, der über dem Substrat aufgehängt ist, der geeignet ist, sich in einer Bewegungsrichtung zu bewegen, wenn er einer Laplace-Kraft ausgesetzt ist,
- mechanische Verbindungen (20, 22; 296, 298), die diesen beweglichen Teil mit dem Substrat mechanisch verbinden und den beweglichen Teil mit Kontaktplättchen zur Stromversorgung elektrisch verbinden, die auf dem Substrat angeordnet sind,
- mindestens ein Messgerät (76, 102; 146, 148; 176; 202, 204; 264), das geeignet ist, eine physikalische Größe zu messen, die für die Amplitude der Bewegung des beweglichen Teils repräsentativ ist, wobei dieses Messgerät mindestens einen ersten und einen zweiten Teil (80, 82) aufweist,
- einen Hebel (52; 142; 172; 242; 312; 322; 348, 350), der drehbeweglich um eine Drehachse (60; 150) aufgehängt ist, die senkrecht zu der Bewegungsrichtung des beweglichen Teils ist, wobei dieser Hebel einen ersten und einen zweiten Befestigungspunkt (50, 81) aufweist, die verschieden sind, wobei der erste Befestigungspunkt (50) mit dem beweglichen Teil mechanisch verbunden ist, um an den Hebel die Bewegung des beweglichen Teils derart zu übertragen, um den Hebel als Antwort auf eine Bewegung des beweglichen Teils um die Drehachse in Drehung zu versetzen, und wobei der zweite Befestigungspunkt (81) direkt mit dem ersten Teil des Messgeräts mechanisch verbunden ist,
**dadurch gekennzeichnet, dass**:
- der Sensor auch ein Scharnier (66; 144; 174; 244) aufweist, das den Hebel mit dem Substrat mechanisch verbindet, wobei dieses Scharnier von den mechanischen Verbindungen des beweglichen Teils und dem ersten und zweiten Befestigungspunkt verschieden und getrennt ist, wobei dieses Scharnier die Drehung des Hebels um seine Drehachse ermöglicht, und
- der Hebel starr ist, um einen Hebelarmeffekt zu ermöglichen, und
- der zweite Teil des Messgeräts ohne irgendeinen Freiheitsgrad an dem Substrat befestigt ist.

2. Sensor nach Anspruch 1, wobei der zweite Befestigungspunkt (81) näher an der Drehachse (60; 150) des Hebels als der erste Befestigungspunkt (50) ist und der kürzeste Abstand zwischen diesem zweiten Befestigungspunkt und der Drehachse kleiner als ein Zehntel der Länge des Hebels ist.

3. Sensor nach Anspruch 1 oder 2, wobei das Messgerät (76, 102; 146, 148; 264) ein hängender Dehnungsmesser ist, der zusätzlich zu dem ersten und zweiten Teil einen dritten Teil (86) aufweist, der zwischen dem ersten und zweiten Teil angeordnet ist, der über dem Substrat aufgehängt ist.

4. Sensor nach Anspruch 3, wobei die Dicke des dritten Teils (86) mindestens zwei Mal geringer als die Dicke des Hebels ist.

5. Sensor nach Anspruch 1, wobei das Messgerät (176) zwei Beläge (184, 186) aufweist, die einander gegenüberliegen, die eine Kapazität bilden, wobei der einer dieser Beläge mit dem Substrat fest verbunden ist, während der andere dieser Beläge mechanisch mit dem zweiten Befestigungspunkt (81) des Hebels derart verbunden ist, um sich als Antwort auf eine Bewegung des Hebels relativ zu dem anderen Belag zu bewegen.

6. Sensor nach Anspruch 1 oder 2, wobei das Messgerät (202, 204) ein Resonanz-Messgerät ist, umfassend:
- mindestens einen Träger (210), der zwischen dem zweiten Befestigungspunkt und dem Substrat aufgehängt ist,
- eine Elektrode (218), die geeignet ist, den Träger in Schwingungen zu versetzen,
- eine andere Elektrode (226) oder dieselbe Elektrode, um die Schwingungsfrequenz des Trägers zu messen.

7. Sensor nach einem der vorhergehenden Ansprüche, wobei der Sensor mindestens zwei Messgeräte (76, 102; 146, 148; 202, 204; 264) aufweist, die derart angeordnet sind, um jeweils eine Bewegung des Hebels zu messen, die entgegengesetzte Vorzeichen zu der Bewegung hat, die von dem anderen Messgerät gemessen wird.

8. Sensor nach einem der vorhergehenden Ansprüche, wobei das Gewicht des Hebels auf beiden Seiten seiner Drehachse derart verteilt ist, dass der kürzeste Abstand zwischen der Drehachse (60; 150) des Hebels und dem Schwerpunkt des Hebels geringer als 1 % der Länge des Hebels ist.

9. Sensor nach Anspruch 8, wobei
- der Sensor mindestens ein erstes und ein zweites Exemplar (8-13) des mindestens einen elektrischen Leiters aufweist, und
- die Drehachse (60) des Hebels in der Mitte des Hebels in der Richtung seiner Länge angeordnet ist,
- der erste Befestigungspunkt (50) mit dem ersten Exemplar des mindestens einen Leiters mechanisch verbunden ist, und
- der Hebel einen dritten Befestigungspunkt (259) aufweist, der mit dem zweiten Exemplar (248-253) des mindestens einen elektrischen Leiters mechanisch verbunden ist, wobei dieser erste und dritte Befestigungspunkt bezüglich der Drehachse zueinander symmetrisch sind.

10. Sensor nach einem der vorhergehenden Ansprüche, wobei:
- der elektrische Leiter (292) derart starr ist, um sich nicht unter der Wirkung der Laplace-Kraft zu verformen, und
- die mechanischen Verbindungen (296, 298) nach Art eines Mäanders geformt sind, um dem elektrischen Leiter zu ermöglichen, sich zu bewegen, wenn er der gleichen Laplace-Kraft ausgesetzt ist.

11. Sensor nach einem der vorhergehenden Ansprüche, wobei der bewegliche Teil mit dem ersten Befestigungspunkt (50) des Hebels über eine mechanische Verbindung (344, 356) in Form eines Mäanders mechanisch verbunden ist, die derart angeordnet ist, dass die Steifigkeit dieser mechanischen Verbindung in der Bewegungsrichtung des beweglichen Teils mindestens fünf Mal größer als ihre Steifigkeit in einer Richtung ist, die orthogonal zu dieser Bewegungsrichtung ist.

12. Sensor nach einem der vorhergehenden Ansprüche, wobei der Sensor mehrere elektrische Leiter (8-13; 248-253) aufweist, die parallel zueinander angeordnet sind.

13. Verfahren zum Betrieb eines Sensors nach einem der vorhergehenden Ansprüche, wobei dieses Verfahren Folgendes aufweist:
- das Bestromen (330) des elektrischen Leiters mit einer Wechselspannung von der Grundfrequenz f_{A},
- das Erfassen des Signals, das für die Amplitude der Bewegung des beweglichen Teils repräsentativ ist,
**dadurch gekennzeichnet, dass** das Verfahren auch Folgendes aufweist:
- das Bestimmen (332) der Messung des Magnetfeldes nur durch die Komponenten des erfassten Messsignals, das eine Frequenz aufweist, die innerhalb der Breite bei -3dB des Resonanzpeaks liegt, das auf die Frequenz f_{A} in der Spektraldichte der Stärke des erfassten Signals zentriert ist,
- das Bestimmen (334) einer Messung einer Beschleunigung in die Bewegungsrichtung des elektrischen Leiters nur durch die Komponenten des gleichen erfassten Messsignals, das eine Frequenz aufweist, die mindestens vier Mal niedriger als die Frequenz f_{A} ist.

## Claims

1. Magnetic field sensor with Laplace force, this sensor comprising:
- a substrate (6) extending essentially in a plane called substrate plane,
- at least one electrical conductor (8-13; 248-253; 292) suitable for an electrical current to flow through, this electrical conductor comprising a moving part (18; 292), suspended over the substrate, suitable for being displaced in a direction of displacement when it is subjected to a Laplace force,
- mechanical links (20, 22; 296, 298) mechanically connecting this moving part to the substrate and electrically connecting the moving part to current power supply contact blocks arranged on the substrate,
- at least one gauge (76, 102; 146, 148; 176; 202, 204; 264) suitable for measuring a physical quantity representative of the amplitude of the displacement of the moving part, this gauge comprising at least one first and one second parts (80, 82),
- a suspended lever (52; 142; 172; 242; 312; 322; 348, 350) that can be rotationally displaced about an axis (60; 150) of rotation at right angles to the direction of displacement of the moving part, this lever comprising a first and a second distinct attachment points (50, 81), the first attachment point (50) being mechanically connected to the moving part to transmit the displacement of the moving part to the lever in such a way as to drive the lever in rotation about the axis of rotation in response to a displacement of the moving part, and the second attachment point (81) being directly mechanically connected to the first part of the gauge,
**characterized in that**:
- the sensor also comprises a hinge (66; 144; 174; 244) mechanically connecting the lever to the substrate, this hinge being distinct and separate from the mechanical links of the moving part and from the first and second attachment points, this hinge allowing the rotation of the lever about its axis of rotation, and
- the lever is rigid to allow for a lever arm effect, and
- the second part of the gauge is fixed with no degree of freedom to the substrate.

2. Sensor according to Claim 1, in which the second attachment point (81) is closer to the axis (60; 150) of rotation of the lever than the first attachment point (50), and the shortest distance between this second attachment point and the axis of rotation is less than a tenth of the length of the lever.

3. Sensor according to Claim 1 or 2, in which the gauge (76, 102;146, 148; 264) is a suspended strain gauge, comprising, in addition to the first and second parts, a third part (86), positioned between the first and second parts, suspended over the substrate.

4. Sensor according to Claim 3, in which the thickness of the third part (86) is at least two times less than the thickness of the lever.

5. Sensor according to Claim 1, in which the gauge (176) comprises two armatures (184, 186) facing one another forming a capacitor, one of these armatures being secured to the substrate, while the other of these armatures is mechanically connected to the second attachment point (81) of the lever in such a way as to be displaced relative to the other armature in response to a displacement of the lever.

6. Sensor according to Claim 1 or 2, in which the gauge (202, 204) is a resonant gauge comprising:
- at least one beam (210) suspended between the second attachment point and the substrate,
- an electrode (218) suitable for causing the beam to vibrate,
- another electrode (226) or the same electrode for measuring the frequency of vibration of the beam.

7. Sensor according to any one of the preceding claims, in which the sensor comprises at least two gauges (76, 102; 146, 148; 202, 204; 264) positioned in such a way as to each measure a displacement of the lever, of opposite signs to the displacement measured by the other gauge.

8. Sensor according to any one of the preceding claims, in which the weight of the lever is distributed on either side of its axis of rotation in such a way that the shortest distance between the axis (60; 150) of rotation of the lever and the center of gravity of the lever is less than 1% of the length of the lever.

9. Sensor according to Claim 8, in which:
- the sensor comprises at least one first and one second copies (8-13) of said at least one electrical conductor, and
- the axis (60) of rotation of the lever is situated in the middle of the lever in the direction of its length,
- the first attachment point (50) is mechanically connected to the first copy of said at least one conductor, and
- the lever comprises a third attachment point (259) mechanically connected to the second copy (248-253) of said at least one electrical conductor, these first and third attachment points being symmetrical to one another relative to the axis of rotation.

10. Sensor according to any one of the preceding claims, in which:
- the electrical conductor (292) is rigid so as not to be deformed under the action of the Laplace force, and
- the mechanical links (296, 298) are configured in meander fashion to allow the electrical conductor to be displaced when it is subjected to the same Laplace force.

11. Sensor according to any one of the preceding claims, in which the moving part is mechanically connected to the first attachment point (50) of the lever via a mechanical link (344, 356) in meander form arranged in such a way that the stiffness of this mechanical link in the direction of displacement of the moving part is at least five times greater than its stiffness in a direction orthogonal to this direction of displacement.

12. Sensor according to any one of the preceding claims, in which the sensor comprises a plurality of electrical conductors (8-13; 248-253) positioned parallel to one another.

13. Method for using a sensor conforming to any one of the preceding claims, this method comprising:
- supplying (330) the electrical conductor with an alternating current of fundamental frequency f_{A},
- acquiring the signal representative of the amplitude of the displacement of the moving part, **characterized in that** the method also comprises:
- determining (332) the measurement of the magnetic field only from the components of the acquired measurement signal having a frequency lying within the width at -3dB of the resonance peak centered on the frequency f_{A} in the power spectral density of the acquired signal,
- determining (334) a measurement of an acceleration in the direction of displacement of the electrical conductor only from the components of the same acquired measurement signal having a frequency at least four times less than the frequency f_{A}.
